# EUROPÄISCHE PATENTSCHRIFT

(11) **EP 3 965 169 B1**
(45) Veröffentlichungstag und Bekanntmachung des Hinweises auf die Patenterteilung: **15.02.2023**
(21) Anmeldenummer: 20000323.4
(22) Anmeldetag: 07.09.2020
(51) Int. Cl.: H01L 31/0687, H01L 31/0304, H01L 31/054

(54) **STAPELFÖRMIGE MONOLITHISCHE MEHRFACHSOLARZELLE**
STACKED MONOLITHIC MULTI-JUNCTION SOLAR CELL
CELLULE SOLAIRE MULTIPLE MONOLITHIQUE EMPILÉE

(43) Veröffentlichungstag der Anmeldung: 09.03.2022
(73) Patentinhaber: AZUR SPACE Solar Power GmbH, 74072 Heilbronn (DE)
(72) Erfinder: Berg Alexander, 74074 Heilbronn (DE); Meusel Matthias, 74076 Heilbronn (DE)
(74) Vertreter: Koch Müller Patentanwaltsgesellschaft mbH

(56) Entgegenhaltungen:
- EP-A1- 2 251 912
- DE-A1-102014 210 753
- US-A1- 2020 251 603
- US-B1- 6 660 928
- W. GUTER ET AL: "Space Solar Cells - 3G30 and Next Generation Radiation Hard Products", E3S WEB OF CONFERENCES, Bd. 16, 2017, Seiten 03005-1-03005-6, XP055464646, DOI: 10.1051/e3sconf/20171603005
- BETT A. W. ET AL: "Highest Efficiency Multi-Junction Solar Cell for Terrestrial and Space Applications", PROCEEDINGS OF THE 24TH EUROPEAN PHOTOVOLTAIC SOLAR ENERGY CONFERENCE, 21. September 2009 (2009-09-21), Seiten 1-6, XP040529663, ISBN: 978-3-936338-25-6
- Jan Schöne: "Kontrolle von Spannungsrelaxation und Defektbildung in metamorphen III-V Halbleiterheterostrukturen für hocheffiziente Solarzellen", Dissertation, 21. Juli 2009 (2009-07-21), Seiten 1-146, XP055528372, Gefunden im Internet: URL:https://d-nb.info/1019870907/34 [gefunden am 2018-11-29]

## Beschreibung

Die Erfindung betrifft eine stapelförmige monolithische Mehrfachsolarzelle.

Eine stapelförmige monolithische Mehrfachsolarzelle ist beispielsweise aus der DE 10 2005 000 767 A1 bekannt. Die Mehrfachsolarzelle umfasst eine erste Germanium-Teilzelle sowie mindestens zwei weitere Teilzellen und mindestens einen Halbleiterspiegel, wobei der Halbleiterspiegel mehrere Schicht mit zumindest voneinander abweichenden Brechungsindizes sowie einen hohen Reflexionsgrad in zumindest einem Teil des Absorptionsbereichsdes oder der darüber angeordneten Teilzellen sowie einen hohen Transmissionsgrad für Strahlung im spektralen Absorptionsbereich der unterhalb des Halbleiterspiegel angeordneten Teilzellen aufweist.

Aus der DE 10 2015 016 047 A1 ist eine stapelförmige monolithische III-V-Mehrfachsolarzelle mit einer ersten Germanium-Teilzelle und einer folgenden Indium und Phosphor aufweisenden zweiten Teilzelle. Weisen die erste und zweite Teilzelle unterschiedliche Gitterkonstanten auf, so umfasst die Mehrfachsolarzelle einen zwischen erster und zweiter Teilzelle angeordneten metamorphen Puffer.

Eine ähnliche Mehrfachsolarzelle ist aus der DE 10 2015 016 822 A1 bekannt.

Aus der US 2020 251 603 A1, aus W. Guter et al: "Space solar cells- 3G30 and Next Generation Radiation Hard Products", E3S WEB OF CONFERENCES, Bd. 16, 2017, S. 03005-1-03005-6, aus Bett A. W. et al: "Highest efficiency multi-junction solar cell for terrestrial and space applications", PROCEEDINGS OF 24th EUROPEAN PHOTOVOLTAIC SOLAR ENERGY CONFERENCE, 21.09.2009, S.1-6, aus Jan Schöne: "Kontrolle von Spannungsrelaxation und Defektbildung in metamorphen III-V Halbleiterheterostrukturen für hocheffiziente Solarzellen", Dissertation, 21.07.2009, S. 1-146, der EP 2 251 912 A1, der DE 10 2014 210 753 A1 und der US 6,660,928 B1 sind Mehrfachsolarzellen bekannt.

Aus der EP 2 251 912 A1 ist eine stapelförmige metamorphe Mehrfachsolarzelle bekannt, wobei die zwischen den Teilzellen angeordneten Tunneldioden jeweils eine kompressiv verspannte erste Schicht und eine tensil verspannte zweite Schicht aufweisen, so dass jede Tunneldiode insgesamt spannungskompensiert ausgeführt ist.

Vor diesem Hintergrund besteht die Aufgabe der Erfindung darin, eine Vorrichtung anzugeben, die den Stand der Technik weiterbildet.

Die Aufgabe wird durch eine stapelförmige monolithische Mehrfachsolarzelle mit den Merkmalen des Patentanspruchs 1 gelöst. Vorteilhafte Ausgestaltungen der Erfindung sind Gegenstand von Unteransprüchen.

Als Gegenstand der Erfindung wird eine stapelförmige monolithische Mehrfachsolarzelle bereitgestellt, aufweisend eine erste Teilzelle, eine zweite Teilzelle, eine dritte Teilzelle und mindestens eine vierte Teilzelle in der genannten Reihenfolge aufeinander folgend, wobei die Bandlücke beginnend von der ersten Teilzelle in Richtung zu der vierten Teilzelle von Teilzelle zu Teilzelle größer wird.

Jede Teilzelle weist einen n-dotierten Emitter und eine p-dotierte Basis auf, wobei der Emitter und die Basis der ersten Teilzelle jeweils Germanium aufweisen oder aus Germanium bestehen und alle auf die erste Teilzelle folgenden Teilzellen jeweils mindestens ein Element der III. Hauptgruppe des Periodensystems und ein Element der V. Hauptgruppe des Periodensystems aufweisen.

Zwischen jeweils zwei Teilzellen ist jeweils eine Tunneldiode mit einem p-n Übergang angeordnet.

Alle auf die erste Teilzelle folgenden Teilzellen sind zueinander gitterangepasst ausgebildet.

Zwischen der ersten Teilzelle und der folgenden zweiten Teilzelle ist ein Halbleiterspiegel aufweisend mehrere n-dotierte Halbleiterschichten mit alternierend unterschiedlichen Brechungsindizes angeordnet.

Zwischen der ersten Teilzelle und dem Halbleiterspiegel ist ein n-dotierter metamorpher Puffer angeordnet ist, wobei der metamorphe Puffer mindestens vier Stufen-Schichten und mindestens eine Überschussschicht aufweist.

Zwischen dem n-dotierten Halbleiterspiegel und der zweiten Teilzelle ist eine erste Tunneldiode ausgebildet, wobei die erste Tunneldiode metamorph ausgebildet ist.

Die n-dotierte Schicht der metamorphen Tunneldiode besteht aus InGaAs oder umfasst InGaAs.

Der In-Anteil bezogen auf den Anteil der Gruppe III Elemente bei der III-V Verbindung der n-dotierten Schicht der metamorphen Tunneldiode beträgt mindestens 20%. Vorzugsweise ist die n-dotierte Schicht mit Tellur dotiert.

Es sei angemerkt, dass bei einer metamorphen Tunneldiode die n-dotierte Schicht eine etwas andere Gitterkonstante als die darüberliegende zweite Teilzelle aufweist und / oder n-dotierte Schicht eine etwas andere Gitterkonstante als die p-dotierte Schicht der ersten Tunneldiode aufweist. Vorzugsweise ist der Unterschied zwischen den Gitterkonstanten größer als 0,1% oder größer als 0,3 % und kleiner als 10% oder kleiner als 5% oder kleiner als 3% oder kleiner als 2%.

Es versteht sich, dass zwischen zwei aufeinanderfolgenden Teilzellen jeweils eine Tunneldiode angeordnet ist.

In einer Weiterbildung weisen mindestens zwei der Pufferschichten eine Dotierung kleiner als 8•10¹⁷ cm⁻³ auf.

Es sei angemerkt, dass die III-V-Teilzellen und weiteren Schichten der stapelförmigen Mehrfachsolarzelle auf der Ge-Unterzelle, z.B. einem Ge-Substrat, nacheinander epitaktisch gewachsen sind.

Des Weiteren sei angemerkt, dass mit dem Begriff der Überschussschicht eine Schicht des metamorphen Puffers, die eine größere Gitterkonstante als die Gitterkonstante der ersten Teilzelle und eine größere Gitterkonstante als die Gitterkonstante der zweiten Teilzelle bzw. der folgenden Teilzellen aufweist, bezeichnet ist.

Vorliegend handelt es sich um eine aufrecht gewachsene metamorphe Mehrfachsolarzelle, sogenannte UMM-Solarzellenanordnung, ohne Halbleiterbond oder Waferbond. Anders ausgedrückt, alle Teilzellen der Mehrfachzelle sind nacheinander epitaktisch in einer MOVPE Anlage aufeinander gewachsen und nicht aus zwei Teilstapel gefügt.

Die erste Teilzelle weist die kleinste Bandlücke und die vierte Teilzelle bei insgesamt vier Teilzellen die größte Bandlücke auf. Bei mehr als vier Teilzellen weist entsprechend die oberste Teilzelle die größte Bandlücke auf.

Vorzugsweise sind alle Teilzellen mit einer n-über-p-Struktur ausgebildet, weisen folglich einen n-dotiertem Emitter über einer p-dotierter Basis auf.

Im Unterschied zu der üblichen Anordnung des Halbleiterspiegels direkt unterhalb einer Teilzelle, z. B. direkt unterhalb der zweiten Teilzelle, ist der Halbleiterspiegel vorliegend unterhalb der ersten Tunneldiode angeordnet. Außerdem ist der Halbleiterspiegel im Unterschied zu der üblichen p-dotierten Ausführung n-dotiert ausgebildet.

Zusätzlich weist die mit Tellur n-dotierte Schicht der ersten Tunneldiode InGaAs auf, wodurch die Schicht bzw. Tunneldiode im Vergleich zu z.B. einer n-InAIP-Schicht zuverlässig der thermischen Last während des folgenden weiteren Wachstums der weiteren Teilzellen gewachsen ist.

Überraschend ist, dass mit einer Reduzierung der Dotierung bei den Schichten eines n-dotierten metamorphen Puffers unter einen Wert von 1•10¹⁸ cm⁻³ der Wirkungsgrad der Mehrfachsolarzelle steigt.

Bisher ist man davon ausgegangen, dass es für die Leitfähigkeit vorteilhaft ist, die Dotierung der Pufferschichten in einem Bereich oberhalb von 1•10¹⁸ cm⁻³ zu wählen.

Des Weiteren ist üblicherweise der Halbleiterspiegel zur Erhöhung der Strahlungsstabilität einer Teilzelle bei gegebener Teilzellendicke direkt unterhalb der betreffenden Teilzelle d.h. unmittelbar unterhalb der p-dotierten Basis einer Teilzelle angeordnet und daher ebenfalls p-dotiert ausgeführt.

Es versteht sich, dass ein Halbleiterspiegel eine Vielzahl von Perioden aus dünnen Schichten aufweist, wobei die dünnen Schichten abwechselnd einen niedrigen und einen hohen Brechungsindex aufweisen.

Vorzugsweise umfasst eine Periode wenigstens zwei oder drei Schichten, wobei der Halbleiterspiegel wenigstens zehn Schichten, d.h. wenigstens 5 Perioden umfasst. In einer Weiterbildung umfasst der Halbleiterspiegel wenigstens 10 oder wenigstens 15 Perioden.

Im Unterschied hierzu wird eine Tunneldiode zwischen dem Halbleiterspiegel und der darüber folgenden Teilzelle, also der zweiten Teilzelle, angeordnet sodass der Halbleiterspiegel n-dotiert ausgebildet ist.

Überraschenderweise zeigte sich, dass bei Anordnung der Tunneldiode zwischen p-dotierter Basis und Halbleiterspiegel der Halbleiterspiegel bei unverändert gutem Reflexionsverhalten eine deutlich höhere Transmission in Bezug auf die darunterliegenden Teilzellen aufweist und sich der Wirkungsgrad der Mehrfachzelle erhöhen lässt.

Die Anordnung bestehend aus n-Dotierung der Schichten des Halbleiterspiegels in Verbindung mit einem niedrigen n-dotierten metamorphen Puffer führt zu einer Steigerung des Photostroms in der Ge Teilzelle.

In einer Weiterbildung ist die mit Tellur n-dotierte Schicht der ersten Tunneldiode mindestens mit 1•10¹⁹ cm⁻³ oder mindestens mit 5•10¹⁸ cm⁻³ dotiert.

In einer anderen Weiterbildung weist die n-dotierte Schicht der ersten Tunneldiode weniger als 1% P auf.

In einer Ausführungsform weist die n-dotierte Schicht der ersten Tunneldiode weniger als 1% Al auf.

In einer anderen Ausführungsform enthält die p-dotierte Schicht der ersten Tunneldiode mindestens die Elemente In, Ga und As.

Vorzugsweise beträgt die Dicke der n-dotierten Schicht als auch die Dicke der p-dotierten Schicht der ersten Tunneldiode mindestens 10 nm und höchstens 100 nm.

In einer Weiterbildung ist die p-dotierte Schicht der ersten Tunneldiode um mindestens 0,5% im Vergleich zum n-dotierten Teil verspannt. Anders ausgedrückt, die Gitterkonstante der p-dotierten Schicht ist um mindestens 0.030 Å geringer als die der n-dotierten Schicht.

Vorzugsweise weist der metamorphe Puffer mindestens drei Halbleiterschichten oder genau vier oder genau fünf oder genau sechs oder vorzugsweise sieben oder genau acht oder genau neun Schichten auf. Es versteht sich, dass die Überschussschichten als Teil des metamorphen Puffers ausgebildet sind.

Vorzugsweise weist der metamorphe Puffer eine sich graduell, z.B. stufenförmig oder rampenförmig von einem ersten Gitterkonstantenwert auf einen zweiten Gitterkonstantenwert ändernde Gitterkonstante auf.

In einer Weiterbildung weisen mindestens zwei der Pufferschichten des metamorphen Puffers eine Dotierung kleiner als 5•10¹⁷ cm⁻³ oder kleiner als 3•10¹⁷ cm⁻³ oder kleiner als 1•10¹⁷ cm⁻³ oder kleiner als 7•10¹⁶ cm⁻³ oder kleiner als 4•10¹⁶ cm⁻³ auf.

Vorzugsweise umfassen oder bestehen die Halbleiterschichten des metamorphen Puffers üblicherweise aus InGaAs. In einer Ausführungsform weist oder besteht die Überschussschicht AlInGaAs auf, um die Transparenz für die darunterliegende Ge Zelle zu erhöhen.

Es sei angemerkt, dass sich die Stöchiometrie von Schicht zu Schicht des metamorphen Puffers ändert, um die Gitterkonstante von Schicht zu Schicht zu ändern. Vorzugsweise ändert sich die Konzentration von Indium von Schicht zu Schicht in einem Bereich zwischen 2% bis 5%.

In einer Ausführungsform unterscheiden sich die Schichten des metamorphen Puffers nicht mehr als einen Faktor zwei in der maximalen Höhe der Dotierungskonzentration.

In einer Weiterbildung umfasst der metamorphe Puffer eine zweite Überschussschicht.

In einer Ausführungsform weisen die Schichten des Halbleiterspiegels eine Dotierung kleiner als 1•10¹⁹ cm⁻³ oder kleiner als 5•10¹⁸ cm⁻³ oder kleiner als 3•10¹⁸ cm⁻³ oder kleiner als 1,5·10¹⁸ cm⁻³ oder kleiner als 8•10¹⁷ cm⁻³ oder kleiner als 5•10¹⁷ cm⁻³ auf.

In einer Ausführungsform weist der Halbleiterspiegel und die Schichten des metamorphen Pufferns Silizium oder Tellur als Dotierstoff auf.

In einer Weiterbildung weisen die Schichten des Halbleiterspiegels mit einem niedrigeren Brechungsindex eine niedrigere Dotierung und/oder einen unterschiedlichen Dotierstoff im Unterschied zu den Schichten des Halbleiterspiegels mit höherem Brechungsindex auf.

In einer Ausführungsform weisen die Schichten des Halbleiterspiegels mit einem niedrigeren Brechungsindex eine um mindestens einen Faktor 2 niedrigere Dotierung auf als Schichten des Halbleiterspiegels mit höherem Brechungsindex.

Vorzugsweise bestehen oder umfassen die Schichten des Halbleiterspiegels mit einem niedrigeren Brechungsindex AlInAs. In einer Ausführungsform weisen die Schichten des Halbleiterspiegels mit einem niedrigeren Brechungsindex kein Gallium auf.

In einer Weiterbildung weisen die Schichten des Halbleiterspiegels eine Dotierung größer als 5•10¹⁶ cm⁻³ oder größer als 1•10¹⁷ cm⁻³ oder größer als 5•10¹⁷ cm⁻³ auf.

In einer Ausführungsform weisen mindestens zwei der Pufferschichten oder alle Pufferschichten eine Dotierung kleiner als die Dotierung der Schichten des Halbleiterspiegels auf.

In einer anderen Weiterbildung weist die Mehrfachsolarzelle eine fünfte Teilzelle auf.

In einer anderen Ausführungsform weist die zweite Teilzelle InGaAs auf oder besteht aus InGaAs.

Alternativ oder ergänzend weist die dritte Teilzelle GaAs oder AlInGaAs oder InGaAsP auf oder besteht aus GaAs oder aus AlInGaAs oder InGaAsP.

In einer Ausführungsform weist die vierte Teilzelle AlInGaP oder InAlP auf oder besteht aus AlInGaP oder aus oder InAlP.

Mit dem Begriff "aufweist" wird ausgedrückt, dass die entsprechende Teilzelle neben dem genannten Material auch weitere Materialien, in Ausführungsformen insbesondere weitere Elemente der III. und/oder V. Hauptgruppe aufweist. Im Unterschied hierzu drückt der Begriff "bestehen aus" aus, dass die Solarzelle im Wesentlichen aus dem genannten Materialien besteht und insbesondere keine weiteren Elemente der III. und/oder V. Hauptgruppe aufweist.

Es versteht sich, dass jede Solarzelle neben den genannten Materialien zusätzlich Dotierstoffe, z.B. Tellur oder Silizium, und gegebenenfalls auch Verunreinigungen aufweist.

In einer Weiterbildung weist die Mehrfachsolarzelle eine fünfte Teilzelle auf, wobei die fünfte Teilzelle zwischen der vierten Teilzelle und der dritten Teilzelle angeordnet ist und InGaP aufweist oder aus InGaP besteht. In einer Weiterbildung ist die fünfte Teilzelle auf der vierten Teilzelle ausgebildet.

In einer Weiterbildung weist die Mehrfachsolarzelle genau vier Teilzellen auf, wobei die vierte Teilzelle eine Bandlücke zwischen 2,0 eV und 1,8 eV aufweist und die die dritte Teilzelle eine Bandlücke zwischen 1,4 eV und 1,6 eV aufweist und die zweite Teilzelle eine Bandlücke zwischen 1 eV und 1,2 eV aufweist und die erste Teilzelle eine Bandlücke zwischen 0,6 eV und 0,7 eV aufweist.

Alternativ sind eine oder mehrere der Teilzellen als Hetero-Teilzellen ausgebildet. Hierbei weisen der Emitter und die Basis eine unterschiedliche Komposition an Elementen auf. Es versteht sich jedoch, dass die Gitterkonstanten von Emitter und Basis bei den jeweiligen Teilzellen gleich sind.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und vertikale Erstreckung sind nicht maßstäblich und weisen, sofern nicht anders angegeben, auch keine ableitbaren geometrischen Relationen zueinander auf. Darin zeigen, die
- Figur 1: eine Ansicht einer ersten Ausführungsform einer stapelförmigen monolithischen Mehrfachsolarzelle,
- Figur 2: eine Ansicht einer zweiten Ausführungsform,

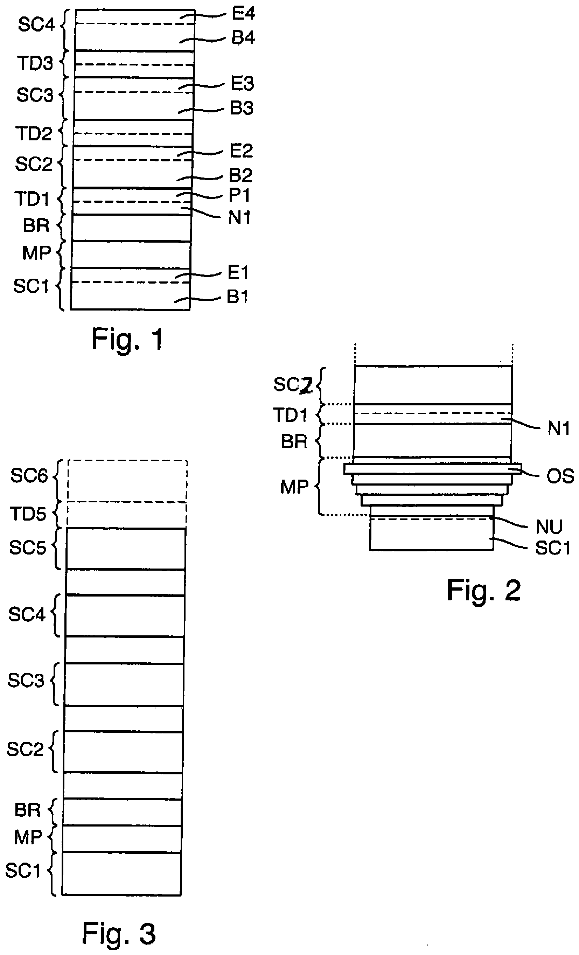

Die Abbildung der Figur 1 zeigt einen schematischen Querschnitt durch eine Mehrfachsolarzelle mit vier stapelförmig angeordneten monolithischen Teilzellen SC1, SC2, SC3 und SC4.

Jede Teilzelle weist eine p-dotierte Basis B1, B2, B3 bzw. B4 und einen n-dotierten Emitter E1, E2, E3 bzw. E4 auf, wobei Emitter E1 und Basis B1 der ersten Teilzelle SC1 Germanium aufweisen oder aus Germanium bestehen und Emitter E2, E3 und E4 sowie Basis B2, B3, B4 der auf die erste Teilzelle SC1 folgenden Teilzellen SC2, SC3 und SC4 jeweils mindestens ein Element der III. Hauptgruppe und mindestens ein Element der V. Hauptgruppe aufweisen.

Jede der weiteren Teilzellen SC2, SC3 und SC4 ist entweder als Homo-Teilzellen oder als Hetero-Teilzelle ausgebildet.

Die Teilzellen SC1, SC2, SC3 und SC4 weisen von der ersten Teilzelle SC1 in Richtung der vierten Teilzelle SC4 von Teilzelle zu Teilzelle zunehmende Bandlücken auf.

Die zweite, dritte und vierte Teilzelle SC2, SC3 und SC4 sind zueinander gitterangepasst ausgeführt, während die erste Teilzelle SC1 eine sich von der Gitterkonstanten der weiteren Teilzellen SC2, SC3 und SC4 unterscheidende Gitterkonstante aufweist.

Um den Unterschied in der Gitterkonstante auszugleichen, weist die stapelförmige Mehrfachsolarzelle zusätzlich einen metamorphen Puffer MP mit sich entlang einer Höhe des metamorphen Puffers MP ändernden Gitterkonstanten auf.

Der metamorphe Puffer MP in der Figur 2 ist zwischen einer Oberseite der ersten Teilzelle SC1 und einer Unterseite des Halbleiterspiegels BR angeordnet und n-dotiert. Die Gitterkonstante des metamorphen Puffers MP ändert sich beispielsweise entlang der Höhe rampen- oder stufenförmig von einem der Gitterkonstanten der ersten Teilzelle SC1 entsprechenden Wert bis zu einem der Gitterkonstanten der zweiten Teilzelle SC2 entsprechenden Wert und weist eine Überschussschicht auf, so dass die Gitterkonstante von Schicht zu Schicht erst zu und dann wieder auf den Wert der Gitterkonstante der zweiten Teilzelle SC2 abnimmt.

Der metamorphe Puffer MP ist n-dotiert und umfasst mindestens vier Stufen-Schichten und mindestens eine Überschussschicht. Mindestens zwei der Pufferschichten weisen eine Dotierung kleiner als 8•10¹⁷ cm⁻³ auf.

Vorzugsweise ist der Unterschied in der Dotierung der Schichten des metamorphen Puffers zueinander kleiner als ein Faktor 2.

Auf einer Oberseite der ersten Teilzelle SC1 ist ein an den Emitter E1 der ersten Teilzelle SC1 angrenzender Halbleiterspiegel BR angeordnet. Der Halbleiterspiegel BR weist mehrere n-dotierte Halbleiterschichten mit alternierend unterschiedlichen Brechungsindizes und einer Dotierstoffkonzentration von jeweils höchstens 1•10¹⁹ cm⁻³ oder höchstens 5•10¹⁸ cm⁻³ auf.

Auf einer Oberseite des Halbleiterspiegels BR und an die Basis B2 der zweiten Teilzelle SC2 angrenzend ist eine erste Tunneldiode TD1 mit einer an den Halbleiterspiegel angrenzenden n-dotierten Schicht N1 und einer an die zweite Teilzelle SC2 angrenzenden p-dotierten Schicht P1 angeordnet.

Anders ausgedrückt, die erste Tunneldiode TD1 ist zwischen dem n-dotierten Puffer MP und der zweiten Teilzelle SC2 angeordnet. Des Weiteren weist die erste Tunneldiode TD1 eine mit Tellur n-dotierte InGaAs-Schicht N1 auf.

Die n-dotierte Schicht N1 der ersten Tunneldiode TD1 ist unterhalb einer p-dotierten Schicht P1 angeordnet. Hierdurch ist die n-dotierte Schicht N1 vorzugsweise stoffschlüssig mit der obersten Schicht des Halbleiterspiegels BR verbunden.

Mit der erfindungsgemäßen Ausführung der n-dotierten Schicht N1 der Tunneldiode wird die n- Schicht N1 bzw. die gesamte erste Tunneldiode TD1 im Vergleich z.B. zu einer n-InAlP-Schicht sehr stabil gegenüber der thermischen Last durch das weitere Wachstums der III-V Schichten der Teilzellen SC2, SC3 und SC4.

Es sei angemerkt, dass im Unterschied zu der üblichen Anordnung bei der der Halbleiterspiegel BR direkt unterhalb einer Teilzelle, z. B. direkt unterhalb der zweiten Teilzelle SC2, angeordnet ist, vorliegend der Halbleiterspiegel BR unterhalb der ersten Tunneldiode TD1 angeordnet.

Entsprechend ist der Halbleiterspiegel BR im Unterschied zu der üblichen p-dotierten Ausführung n-dotiert ausgebildet.

Eine zweite Tunneldiode TD2 ist zwischen der zweiten Teilzelle SC2 und der dritten Teilzelle SC3 und eine dritte Tunneldiode TD3 ist zwischen der dritten Teilzelle SC3 und der vierten Teilzelle SC4 angeordnet, wobei jede Tunneldiode TD1, TD2 sowie TD3 jeweils einen p-n Übergang, also eine n-dotierte Schicht und eine p-dotierte Schicht aufweist.

In der Abbildung der Figur 3 ist eine weitere Ausführungsform dargestellt. Im Folgenden werden nur die Unterschiede zu der Abbildung der Figur 1 erläutert.

Die Mehrfachsolarzelle ist als metamorphe Fünffach-Solarzelle ausgebildet, wobei die zweite, dritte, vierte und fünfte Teilzelle SC2, SC3, SC4 und SC5 zueinander gitterangepasst ausgeführt sind, wobei die erste Teilzelle SC1 eine von der Gitterkonstante der folgenden Teilzellen SC2, SC3, SC4 und SC5 abweichende Gitterkonstante aufweist.

Der Unterschied der Gitterkonstanten wird mittels eines zwischen der ersten Teilzelle SC1 und dem Halbleiterspiegel BR angeordneten metamorphen Puffers MP ausgeglichen.

In einer nicht dargestellten Ausführungsform ist die fünfte Teilzelle zwischen der vierten Teilzelle und der dritten Teilzelle angeordnet und weist InGaP auf oder besteht aus InGaP.

## Patentansprüche

1. Stapelförmige monolithische Mehrfachsolarzelle, aufweisend eine erste Teilzelle (SC1), eine zweite Teilzelle (SC2), eine dritte Teilzelle (SC3) und mindestens eine vierte Teilzelle (SC4) in der genannten Reihenfolge aufeinander folgend, wobei
- die Bandlücke beginnend von der ersten Teilzelle (SC1) in Richtung zu der vierten Teilzelle (SC4) von Teilzelle zu Teilzelle größer wird,
- jede Teilzelle (SC1, SC2, SC3, SC4) einen n-dotierten Emitter (E1, E2, E3, E4) und eine p-dotierte Basis (B1, B2, B3, B4) aufweist,
- der Emitter (E1) und die Basis (B1) der ersten Teilzelle (SC1) jeweils Germanium aufweisen oder aus Germanium bestehen,
- alle auf die erste Teilzelle (SC1) folgenden Teilzellen (SC2, SC3, SC4) jeweils mindestens ein Element der III. und der V. Hauptgruppe des Periodensystems aufweisen,
- zwischen jeweils zwei Teilzellen (SC1, SC2, SC3, SC4) jeweils eine Tunneldiode (TD1, TD2, TD3) mit einem p-n Übergang angeordnet ist,
- alle auf die erste Teilzelle (SC1) folgenden Teilzellen (SC2, SC3, SC4) zueinander gitterangepasst ausgebildet sind,
- zwischen der ersten Teilzelle (SC1) und der folgenden zweiten Teilzelle (SC2) ein n-dotierter Halbleiterspiegel (BR) aufweisend mehrere dotierte Halbleiterschichten mit alternierend unterschiedlichen Brechungsindizes angeordnet ist, und
zwischen der ersten Teilzelle (SC1) und dem Halbleiterspiegel (BR) ein n-dotierter metamorpher Puffer (MP) angeordnet ist, **dadurch gekennzeichnet, dass** der metamorphe Puffer mindestens vier Stufen-Schichten und mindestens eine Überschussschicht aufweist, und
die Dotierung der Schichten des n-dotierten metamorphen Puffers unter einen Wert von 1•10¹⁸ cm⁻³ liegt, und
zwischen der zweiten Teilzelle (SC2) und dem n-dotierten Halbleiterspiegel (BR)
eine erste metamorphe Tunneldiode (TD1) angeordnet ist, so dass sich auf der ersten Teilzelle (SC1), der metamorphe Puffer (MP), der Halbleiterspiegel (BR), die erste metamorphe Tunneldiode (TD1) und die zweite Teilzelle (SC2) in der genannten Reihenfolge ausgebildet sind, und
die n-dotierte Schicht (N1) der ersten Tunneldiode (TD1) zwischen dem n-dotierten Halbleiterspiegel (BR) und der zweiten Teilzelle (SC2) aus InGaAs besteht oder InGaAs aufweist, und
der In-Anteil der n-dotierten Schicht (N1) der ersten Tunneldiode zwischen dem n-dotierten Halbleiterspiegel (BR) und der zweiten Teilzelle (SC2) mindestens 20% ist.

2. Stapelförmige monolithische Mehrfachsolarzelle nach einem der vorstehenden Ansprüche, **dadurch gekennzeichnet, dass** die n-dotierte Schicht (N1) der ersten Tunneldiode (TD1) mit mindestens 1•10¹⁹ cm⁻³ dotiert ist.

3. Stapelförmige monolithische Mehrfachsolarzelle nach einem der vorstehenden Ansprüche, **dadurch gekennzeichnet, dass** die n-dotierte Schicht (N1) der ersten Tunneldiode (TD1) mit mindestens 5•10¹⁸ cm⁻³ dotiert ist.

4. Stapelförmige monolithische Mehrfachsolarzelle nach einem der vorstehenden Ansprüche, **dadurch gekennzeichnet, dass** die n-dotierte Schicht (N1) der ersten Tunneldiode (TD1) weniger als 1% P aufweist.

5. Stapelförmige monolithische Mehrfachsolarzelle nach einem der vorstehenden Ansprüche, **dadurch gekennzeichnet, dass** die n-dotierte Schicht (N1) der ersten Tunneldiode (TD1) weniger als 1% Al aufweist.

6. Stapelförmige monolithische Mehrfachsolarzelle nach einem der vorstehenden Ansprüche, **dadurch gekennzeichnet, dass** die p-dotierte Schicht (P1) der ersten Tunneldiode (TD1) mindestens die Elemente In, Ga und As enthält.

7. Stapelförmige monolithische Mehrfachsolarzelle nach einem der vorstehenden Ansprüche, **dadurch gekennzeichnet, dass** sowohl die Dicke der n-dotierten Schicht als auch die Dicke der p-dotierten Schicht (P1) der ersten Tunneldiode (TD1) mindestens 10 nm und höchstens 100 nm dick sind.

8. Stapelförmige monolithische Mehrfachsolarzelle nach einem der vorstehenden Ansprüche, **dadurch gekennzeichnet, dass** die p-dotierte Schicht (P1) der ersten Tunneldiode (TD1) im Vergleich zu der n-dotierten Schicht (N1) der ersten Tunneldiode (TD1) um mindestens 0,5% verspannt ist oder die Gitterkonstante der p-dotierten Schicht (P1) der ersten Tunneldiode (TD1) ist um mindestens 0.030 Ä geringer ist als die der n-dotierten Schicht (N1) der ersten Tunneldiode (TD1).

9. Stapelförmige monolithische Mehrfachsolarzelle nach einem der vorstehenden Ansprüche, **dadurch gekennzeichnet, dass** die n-dotierte Schicht (N1) der ersten Tunneldiode (TD1) mit Tellur dotiert ist.

10. Stapelförmige monolithische Mehrfachsolarzelle nach einem der vorstehenden Ansprüche, **dadurch gekennzeichnet, dass** genau vier Teilzellen vorgesehen sind, wobei die vierte Teilzelle eine Bandlücke zwischen 2,0 eV und 1,8 eV aufweist und die dritte Teilzelle eine Bandlücke zwischen 1,4 eV und 1,6 eV aufweist und die zweite Teilzelle eine Bandlücke zwischen 1 eV und 1,2 eV aufweist und die erste Teilzelle eine Bandlücke zwischen 0,6 eV und 0,7 eV aufweist.

11. Stapelförmige monolithische Mehrfachsolarzelle nach einem der vorstehenden Ansprüche, **dadurch gekennzeichnet, dass** mindestens zwei Schichten des metamorphen Puffers eine Dotierung kleiner als 5·10¹⁷ cm⁻³ oder kleiner als 3•10¹⁷ cm⁻³ oder kleiner als 1•10¹⁷ cm⁻³ oder kleiner als 7•10¹⁶ cm⁻³ oder kleiner als 4•10¹⁶ cm⁻³ aufweisen.

12. Stapelförmige monolithische Mehrfachsolarzelle nach einem der vorstehenden Ansprüche, **dadurch gekennzeichnet, dass** die Schichten des Halbleiterspiegels eine Dotierung kleiner als 1•10¹⁹ cm⁻³ oder kleiner als 5•10¹⁸ cm⁻³ oder kleiner als 3•10¹⁸ cm⁻³ oder kleiner als 1,5·10¹⁸ cm⁻³ oder kleiner als 8•10¹⁷ cm⁻³ aufweisen.

13. Stapelförmige monolithische Mehrfachsolarzelle nach einem der vorstehenden Ansprüche, **dadurch gekennzeichnet, dass** die Schichten des Halbleiterspiegels eine Dotierung größer als 5•10¹⁶ cm⁻³ oder größer als 1•10¹⁷ cm⁻³ oder größer als 5•10¹⁷ cm⁻³ aufweisen.

## Claims

1. Stacked monolithic multi-junction solar cell comprising a first subcell (SC1), a second subcell (SC2), a third subcell (SC3) and at least one fourth subcell (SC4) in the stated sequence following one another, wherein
- the band gap beginning from the first subcell (SC1) is larger from subcell to subcell in direction towards the fourth subcell (SC4),
- each subcell (SC1, SC2, SC3, SC4) comprises an n-doped emitter (E1, E2, E3, E4) and a p-doped base (B1, B2, B3, B4),
- the emitter (E1) and the base (B1) of the first subcell (SC1) each comprise germanium or consist of germanium,
- all subcells (SC2, SC3, SC4) following the first subcell (SC1) each comprise an element of the III and V main group of the periodic system,
- a respective tunnel diode (TD1, TD2, TD3) with a p-n transition is arranged between each two subcells (SC1, SC2, SC3, SC4),
- all subcells (SC2, SC3, SC4) following the first subcell (SC1) are constructed to be lattice-matched to one another,
- an n-doped semiconductor mirror (BR) comprising several doped semiconductor layers with refraction indices differing in alternation is arranged between the first subcell (SC1) and the following second subcell (SC2), and
an n-doped metamorphic buffer (MP) is arranged between the first subcell (SC1) and the semiconductor mirror (BR),
**characterised in that**
the metamorphic buffer comprises at least four step layers and at least one overshoot layer, and
the doping of the layers of the n-doped metamorphic buffer has a value of less than 1• 10¹⁸ cm⁻³, and
a first metamorphic tunnel diode (TD1) is arranged between the second subcell (SC2) and the n-doped semiconductor mirror (BR) so that the metamorphic buffer (MP), the semiconductor mirror (BR), the first metamorphic tunnel diode (TD1) and the second subcell (SC2) formed on the first subcell (SC1) in the stated sequence, and
the n-doped layer (N1) of the first tunnel diode (TD1) between the n-doped semiconductor mirror (BR) and the second subcell (SC2) consists of InGaAs or comprises InGaAs, and the In component of the n-doped layer (N1) of the first tunnel diode between the n-doped semiconductor mirror (BR) and the second subcell (SC2) is at least 20%.

2. Stacked monolithic multi-junction solar cell according to the preceding claim, **characterised in that** the n-doped layer (N1) of the first tunnel diode (TD1) is doped with at least 1 • 10¹⁹ cm⁻³.

3. Stacked monolithic multi-junction solar cell according to either one of the preceding claims, **characterised in that** the n-doped layer (N1) of the first tunnel diode (TD1) is doped with at least 1 • 10¹⁸ cm⁻³.

4. Stacked monolithic multi-junction solar cell according to any one of the preceding claims, **characterised in that** the n-doped layer (N1) of the first tunnel diode (TD1) has less than 1% P.

5. Stacked monolithic multi-junction solar cell according any one of the preceding claims, **characterised in that** the n-doped layer (N1) of the first tunnel diode (TD1) has less than 1% Al.

6. Stacked monolithic multi-junction solar cell according to any one of the preceding claims, **characterised in that** the p-doped layer (P1) of the first tunnel diode (TD1) contains at least the elements In, Ga and As.

7. Stacked monolithic multi-junction solar cell according to any one of the preceding claims, **characterised in that** not only the thickness of the n-doped layer, but also the thickness of the p-doped layer (P1) of the first tunnel diode (TD1) are at least 10 nm and at most 100 nm thick.

8. Stacked monolithic multi-junction solar cell according to any one of the preceding claims, **characterised in that** the p-doped layer (P1) of the first tunnel diode (TD1) is strained by less than 0.5% by comparison with the n-doped layer (N1) of the first tunnel diode (TD1) or the lattice constant of the p-doped layer (P1) of the first tunnel diode (TD1) is smaller by at least 0.030 Å than that of the n-doped layer (N1) of the first tunnel diode (TD1).

9. Stacked monolithic multi-junction solar cell according to any one of the preceding claims, **characterised in that** the n-doped layer (N1) of the first tunnel diode (TD1) is doped with tellurium.

10. Stacked monolithic multi-junction solar cell according to any one of the preceding claims, **characterised in that** exactly four subcells are provided, wherein the fourth subcell has a band gap between 2.0 eV and 1.8 eV and the third subcell has a band gap between 1.4 eV and 1.6 eV and the second subcell has a band gap between 1 eV and 1.2 eV and the first subcell has a band gap between 0.6 eV and 0.7 eV.

11. Stacked monolithic multi-junction solar cell according to any one of the preceding claims, **characterised in that** at least two layers of the metamorphic buffer have a doping less than 5 • 10¹⁷ cm⁻³ or less than 3 • 10¹⁷ cm⁻³ or less than 1 • 10¹⁷ cm⁻³ or less than 7 • 10¹⁷ cm⁻³ or less than 4 • 10¹⁶ cm⁻³.

12. Stacked monolithic multi-junction solar cell according to any one of the preceding claims, **characterised in that** the layers of the semiconductor mirror have a doping less than 1 • 10¹⁸ cm⁻³ or less than 5 • 10¹⁸ cm⁻³ or less than 3 • 10¹⁸ cm⁻³ or less than 1.5 • 10¹⁸ cm⁻³ or less than 8 • 10¹⁷ cm⁻³.

13. Stacked monolithic multi-junction solar cell according to any one of the preceding claims, **characterised in that** the layers of the semiconductor mirror have a doping greater than 5 • 10¹⁶ cm⁻³ or greater than 1 • 10¹⁷ cm⁻³ or greater than 5 • 10¹⁷ cm⁻³.

## Revendications

1. Cellule solaire multiple monolithique empilée, comprenant une première sous-cellule (SC1), une deuxième sous-cellule (SC2), une troisième sous-cellule (SC3) et au moins une quatrième sous-cellule (SC4) se succédant dans l'ordre indiqué, où :
- la bande interdite augmente de sous-cellule en sous-cellule, en commençant par la première sous-cellule (SC1) et en allant vers la quatrième sous-cellule (SC4) ;
- chaque sous-cellule (SC1, SC2, SC3, SC4) présente un émetteur dopé n (E1, E2, E3, E4) et une base dopée p (B1, B2, B3, B4) ;
- l'émetteur (El) et la base (B1) de la première sous-cellule (SC1) comportent chacun du germanium ou sont constitués de germanium ;
- toutes les sous-cellules (SC2, SC3, SC4) qui suivent la première sous-cellule (SC1) comportent chacune au moins un élément des groupes principaux III et V du tableau périodique ;
- entre chaque sous-cellule (SC1, SC2, SC3, SC4) est disposée une diode tunnel (TD1, TD2, TD3) avec une jonction p-n,
- toutes les sous-cellules (SC2, SC3, SC4) qui suivent la première sous-cellule (SC1) sont réalisées avec un appariment réticulaire les unes aux autres,
- entre la première sous-cellule (SC1) et la deuxième sous-cellule suivante (SC2) est disposé un miroir semi-conducteur (BR) dopé n, présentant plusieurs couches semi-conductrices dopées ayant différents indices de réfraction alternants, et
- entre la première sous-cellule (SC1) et le miroir semi-conducteur (BR) est disposé un buffer métamorphe (MP) dopé n, **caractérisé en ce que**
- le buffer métamorphe présente au moins quatre couches étagées et au moins une couche excédentaire et où le dopage des couches du buffer métamorphe dopé n est inférieur à une valeur de 1●10¹⁸ cm⁻³, et
- une première diode tunnel métamorphique (TD1) est disposée entre la deuxième sous-cellule (SC2) et le miroir semi-conducteur dopé n (BR), de sorte que sur la première sous-cellule (SC1), le buffer métamorphe (MP), le miroir semi-conducteur (BR), la première diode tunnel métamorphe (TD1) et la deuxième sous-cellule (SC2) sont formés dans l'ordre mentionné, et
- la couche dopée n (N1) de la première diode tunnel (TD1) entre le miroir semi-conducteur dopé n (BR) et la deuxième sous-cellule (SC2) est constituée d'InGaAs ou présente de l'InGaAs, et
- la proportion de In de la couche dopée n (N1) de la première diode tunnel entre le miroir semi-conducteur dopé n (BR) et la deuxième sous-cellule (SC2) est d'au moins 20%.

2. Cellule solaire multiple monolithique empilée selon l'une des revendications précédentes, **caractérisée en ce que** la couche dopée n (N1) de la première diode tunnel (TD1) est dopée au moins de 1•10¹⁹ cm-³.

3. Cellule solaire multiple monolithique empilée selon l'une des revendications précédentes, **caractérisée en ce que** la couche dopée n (N1) de la première diode tunnel (TD1) est dopée au moins de 5•10¹⁸ cm-³.

4. Cellule solaire multiple monolithique empilée selon l'une des revendications précédentes, **caractérisée en ce que** la couche dopée n (N1) de la première diode tunnel (TD1) présente moins de 1% P.

5. Cellule solaire multiple monolithique empilée selon l'une des revendications précédentes, **caractérisée en ce que** la couche dopée n (N1) de la première diode tunnel (TD1) présente moins de 1% Al.

6. Cellule solaire multiple monolithique empilée selon l'une des revendications précédentes, **caractérisée en ce que** la couche dopée p (P1) de la première diode tunnel (TD1) comporte au moins les éléments In, Ga et As.

7. Cellule solaire multiple monolithique empilée selon l'une des revendications précédentes, **caractérisée en ce qu'**aussi bien l'épaisseur de la couche dopée n que l'épaisseur de la couche dopée p (P1) de la première diode tunnel (T1) est au minimum de 10 nm et au maximum de 100 nm.

8. Cellule solaire multiple monolithique empilée selon l'une des revendications précédentes, **caractérisée en ce que** la couche dopée p (P1) de 1a première diode tunnel (TD1) est contrainte d'au moins 0,5% par rapport à la couche dopée n (N1) de la première diode tunnel (TD1) ou bien la constante de réticulation de la couche dopée p (P1) de la première diode tunnel (TD1) est inférieure d'au moins 0,030 Â (Angström) à celle de la couche dopée n (N1) de la première diode tunnel (TD1).

9. Cellule solaire multiple monolithique empilée selon l'une des revendications précédentes, **caractérisée en ce que** la couche dopée n (N1) de la première diode tunnel (TD1) est dopée au tellure.

10. Cellule solaire multiple monolithique empilée selon l'une des revendications précédentes, **caractérisée en ce que** précisément quatre sous-cellules sont prévues, où la quatrième sous-cellule présente une bande interdite entre 2,0 eV et 1,8 eV, la troisième sous-cellule présente une bande interdite entre 1,4 eV et 1,6 eV, la deuxième sous-cellule présente une bande interdite entre 1 eV et 1,2 eV et la première sous-cellule une bande interdite entre 0,6 eV et 0,7 eV.

11. Cellule solaire multiple monolithique empilée selon l'une des revendications précédentes, **caractérisée en ce qu'**au moins deux couches du buffer métamorphe présentent un dopage inférieur à 5•10¹⁷ cm⁻³ ou inférieur à 3•10¹⁷ cm⁻³ ou inférieur à 1•10¹⁷ cm⁻³ ou inférieur à 7•10¹⁶ cm⁻³ ou inférieur à 4•10¹⁶ cm⁻³.

12. Cellule solaire multiple monolithique empilée selon l'une des revendications précédentes, **caractérisée en ce que** les couches du miroir semiconducteur présentent un dopage inférieur à 1•10¹⁹ cm⁻³ ou inférieur à 5•10¹⁸ cm⁻³ ou inférieur à
3•10¹⁸ cm⁻³ ou inférieur à 1,5•10¹⁸ cm⁻³ ou inférieur à 8•10¹⁷ cm⁻³.

13. Cellule solaire multiple monolithique empilée selon l'une des revendications précédentes, **caractérisée en ce que** les couches du miroir semiconducteur présentent un dopage supérieur à 5•10¹⁶ cm⁻³ ou supérieur à 1•10¹⁷ cm⁻³ ou supérieur à 5•10¹⁷ cm⁻³.
